# EUROPEAN PATENT APPLICATION

(11) **EP 4 546 952 A1**
(43) Date of publication of application: **30.04.2025**
(21) Application number: 23847005.8
(22) Date of filing: 26.07.2023
(51) Int. Cl.: H05K 1/18, H05K 1/11, H05K 3/46, H05K 3/34, H04M 1/02, H01L 23/00, H01L 23/12, H01L 23/66

(54) **ELECTRONIC APPARATUS COMPRISING INTERPOSER**

(30) Priority: 29.07.2022 KR 20220094518; 09.08.2022 KR 20220099585; 19.09.2022 KR 20220118225
(71) Applicant: Samsung Electronics Co., Ltd., Suwon-si, Gyeonggi-do 16677 (KR)
(72) Inventor: KIM, Euisup, Suwon-si Gyeonggi-do 16677 (KR); RA, Jaeyeon, Suwon-si Gyeonggi-do 16677 (KR)
(74) Representative: HGF
(86) International application number: PCT/KR2023/010875
(87) International publication number: WO 2024/025348

(57) **Abstract**

According to one embodiment, an electronic apparatus comprises: a printed circuit board including a first non-conductive layer, a conductive pattern disposed on the first non-conductive layer, and a second non-conductive layer, which encompasses the conductive pattern and is disposed on the first non-conductive layer; an interposer disposed on the second non-conductive layer; and a plurality of solders disposed between the interposer and the second non-conductive layer and disposed along at least some of the edges of the interposer. A portion of the conductive pattern can be spaced apart from the edges of portions of the first non-conductive layer that overlap first solders, and can be extended to be bent along some of the edges. Other various embodiments are possible.

## Description

### [Technical Field]

The present disclosure relates to an electronic device comprising an interposer.

### [Background Art]

A thickness of an electronic device is becoming thinner to improve portability. In order to secure a mounting space of the electronic device, an application of a stacked structure of heterogeneous substrates to a printed circuit board in the electronic device is increasing.

In order to secure the mounting space for an electronic component or various electronic elements, the electronic device may stack a plurality of substrates, and include an interposer interposed between the substrates. The electronic component or a plurality of elements disposed on the plurality of substrates may be electrically connected to each other through the interposer.

### [Disclosure]

### [Technical Solution]

According to an embodiment, an electronic device may comprise a printed circuit board. The printed circuit board may include a first non-conductive layer, a conductive pattern, and a second non-conductive layer. The conductive pattern may be disposed on the first non-conductive layer. The second non-conductive layer may surround the conductive pattern, and may be disposed on the first non-conductive layer. The electronic device may further comprise an interposer. The interposer may be disposed on the second non-conductive layer. The electronic device may comprise a plurality of solders. The plurality of solders may be disposed between the interposer and the second non-conductive layer, and may be disposed along at least a portion of a periphery of the interposer. According to an embodiment, the first non-conductive layer may include a first region including portions overlapping with first solders among the plurality of solders when the printed circuit board is viewed from above. According to an embodiment, a first portion of the conductive pattern disposed on the first region may be spaced apart from a periphery of the portions overlapping the first solders, and may extend to bend along a portion of the periphery when the printed circuit board is viewed from above.

According to an embodiment, an electronic device may comprise a housing, a printed circuit board disposed in the housing, an interposer disposed on conductive pads of the printed circuit board, and a plurality of solders disposed between the interposer and the plurality of conductive pads. According to an embodiment, the printed circuit board may include a first non-conductive layer in which the plurality of conductive pads are disposed on a surface, a second non-conductive layer disposed on another surface of the first non-conductive layer opposite to the surface of the first non-conductive layer, and a conductive pattern disposed between a first region of the second non-conductive layer including a portion overlapping with the plurality of solders and the first non-conductive layer, when the printed circuit board is viewed from above. According to an embodiment, the conductive pattern may include a first portion extended meanderingly between portions overlapping with the plurality of solders.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an exemplary electronic device according to an embodiment.
FIG. 3 is a perspective view of a printed circuit board in which an exemplary interposer in an electronic device is disposed according to an embodiment.
FIG. 4 is a cross-sectional view of a printed circuit board on which an exemplary interposer is disposed, cut along line A-A' of FIG. 3, according to an embodiment.
FIG. 5 is a plan view of an exemplary first non-conductive layer on which a solder joint of a printed circuit board is displayed according to an embodiment.
FIG. 6 is a plan view of an exemplary second non-conductive layer on which a conductive pattern of a printed circuit board is printed according to an embodiment.
FIG. 7 is a plan view of an exemplary second non-conductive layer on which a wide conductive pattern of a printed circuit board is printed according to an embodiment.
FIG. 8 is a plan view of an exemplary third non-conductive layer of a printed circuit board according to an embodiment.

### [Mode for Invention]

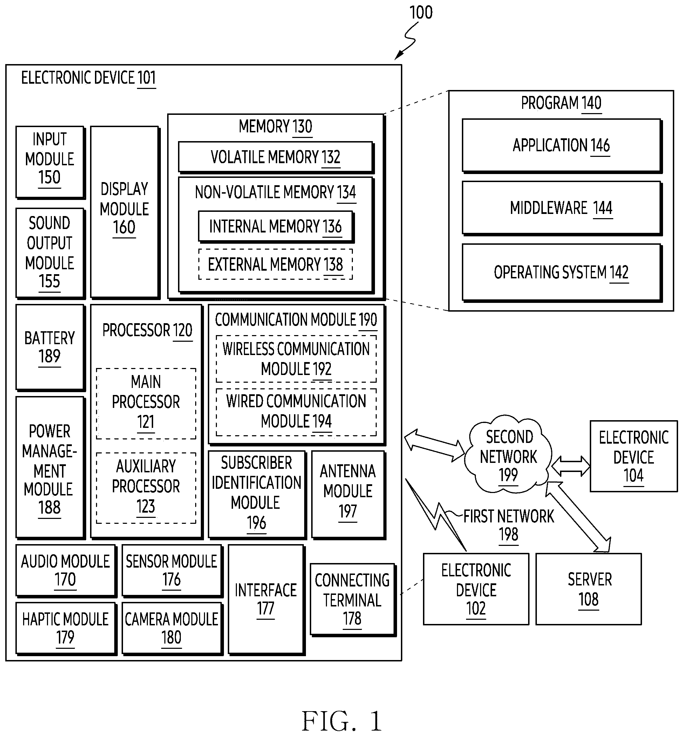

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

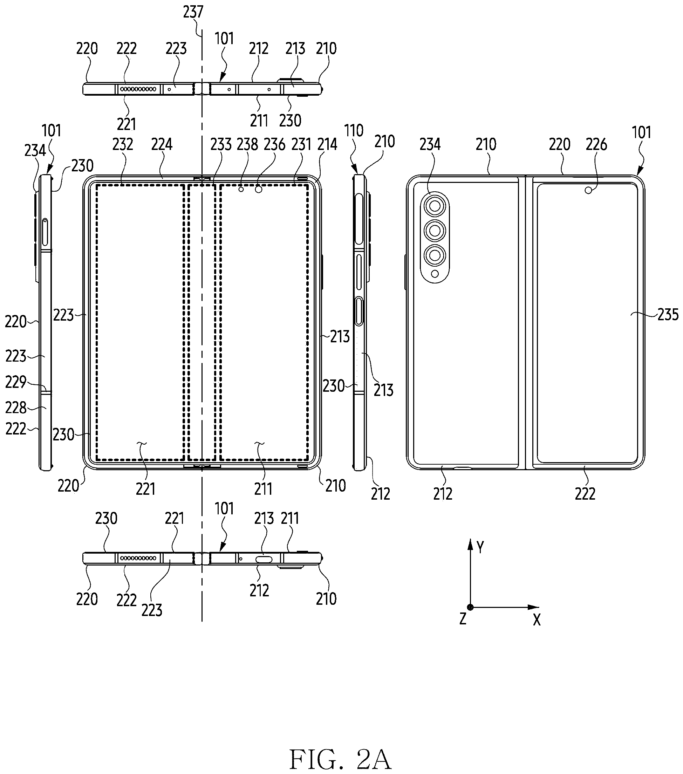

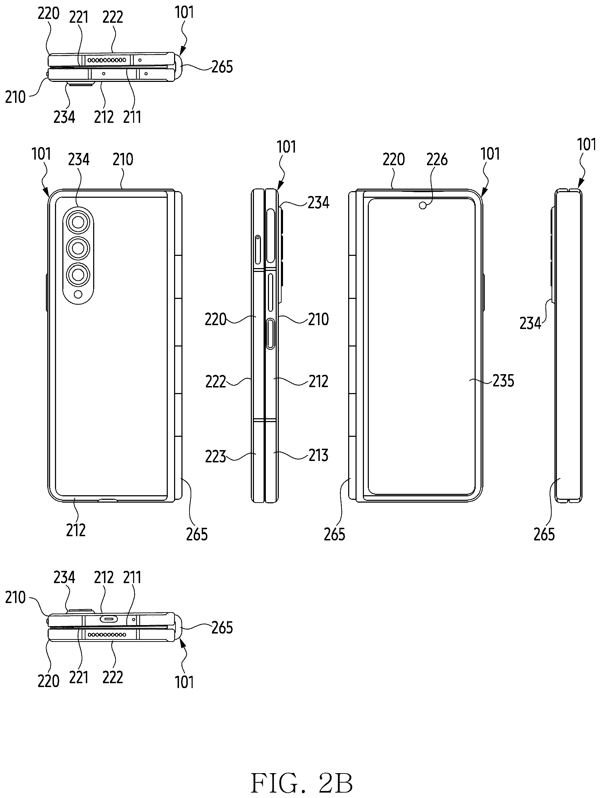

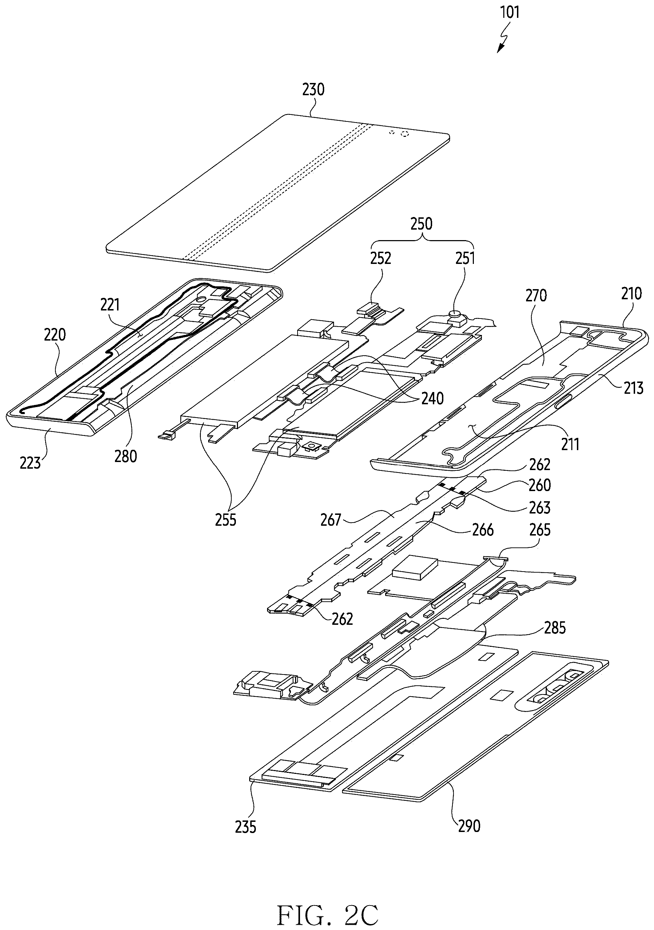

FIG. 2A illustrates an example of an unfolded state of an electronic device according to an embodiment, FIG. 2B illustrates an example of a folded state of an electronic device according to an embodiment, and FIG. 2C is an exploded view of an electronic device according to an embodiment.

Referring to FIGS. 2A, 2B, and 2C, an electronic device 101 may include a first housing 210, a second housing 220, and a flexible display 230. The electronic device 101 may be a device in which the first housing 210 and the second housing 220 may be folded to each other. The electronic device 101 may be referred to as a foldable electronic device.

In an embodiment, the first housing 210 may include a first surface 211, a second surface 212 faced away from the first surface 211, and a first lateral side 213 surrounding at least a portion of the first surface 211 and the second surface 212. In an embodiment, the second surface 212 may further include at least one camera 234 exposed through a portion of the second surface 212. In an embodiment, the first housing 210 may include a first protective member 214 disposed along a periphery of the first surface 211. In an embodiment, the first housing 210 may provide a space formed by the first surface 211, the second surface 212, and the lateral side 213 as a space for mounting components of the electronic device 101.

In an embodiment, the second housing 220 may include a third surface 221, a fourth surface 222 faced away with the third surface 221, and a second lateral side 223 surrounding at least a portion of the third surface 221 and the fourth surface 222. In an embodiment, the fourth surface 222 may further include a display panel 235 disposed on the fourth surface 222. A camera 226 may be disposed to face the fourth surface 222 from the inside of the second housing 220 to obtain an external image through the fourth surface 222. The camera 226 may be covered by the display panel 235 by being disposed in a lower portion of the display panel 235. In an embodiment, the camera 226 may be disposed in the lower portion of the display panel 235, and the display panel 235 may include an opening transmitting light from the outside to the camera 226 by being aligned with lens of the camera 226. According to an embodiment, each of the first housing 210 and the second housing 220 may include the first protective member 214 and a second protective member 224. For example, the first protective member 214 and the second protective member 224 may be disposed on the first surface 211 and the third surface 221 along a periphery of the flexible display 230. The first protective member 214 and the second protective member 214 may prevent an inflow of a foreign substance (e.g., dust or moisture) through a gap between the flexible display 230 and both the first housing 210 and the second housing 220. The first protective member 214 may be disposed along a periphery of a first display region 231, and the second protective member 224 may be disposed along a periphery of a second display region 232. The first protective member 214 may be formed by being attached to the first lateral side 213 of the first housing 210, or may be formed integrally with the first lateral side 213. The second protective member 224 may be formed by being attached to the second lateral side 213 of the second housing 220, or may be formed integrally with the second lateral side 223.

In an embodiment, the first lateral side 213 and the second lateral side 223 may include a conductive material, a non-conductive material, or a combination thereof. For example, the second lateral side 223 may include a conductive member 228 and a non-conductive member 229. The conductive member 228 may include a plurality of conductive members and may be spaced apart from each other. The non-conductive member 229 may be disposed between the plurality of conductive members. In an embodiment, an antenna structure may be formed by a portion of the plurality of conductive members and a portion of a plurality of non-conductive members, or a combination thereof.

In an embodiment, the second lateral side 223 may be pivotably or rotatably connected to the first lateral side 213 through a hinge structure 260 mounted on a hinge cover 265. For example, the hinge structure 260 may include a hinge module 262, a first hinge plate 266, and a second hinge plate 267. The first hinge plate 266 may be connected to the first housing 210, and the second hinge plate 267 may be connected to the second housing 220. In an embodiment, the second housing 220 may provide a space formed by the third surface 221, the fourth surface 222 faced away with the third surface 221 and the lateral side 223 surrounding at least a portion of the third surface 221 and the fourth surface 222 as a space for mounting the components of the electronic device 101.

In an embodiment, the flexible display 230 may include a window exposed toward the outside. The window may protect an external surface of the flexible display 230, and transmit visual information provided from the flexible display 230 to the outside by being formed as a protective layer. The window may include a glass material such as an ultra-thin glass (UTG) or a polymer material such as polyimide (PI). In an embodiment, the flexible display 230 may be disposed on the first surface 211 of the first housing 210 and the third surface 221 of the second housing 220 across the hinge cover 265. The flexible display 230 may include the first display region 231 disposed on the first surface 211 of the first housing, the second display region 232 disposed on the third surface 221 of the second housing, and a third display region 233 between the first display region 231 and the second display region 232. The first display region 231, the second display region 232, and the third display region 233 may form a front surface of the flexible display 230.

According to an embodiment, an opening may be formed in a portion of a screen display region of the flexible display 230, or a recess or an opening may be formed in a support member (e.g., bracket) supporting the flexible display 230. For example, the electronic device 101 may include at least one of a sensor module 238 and a camera 236 that are aligned with the recess or the opening. For example, the first display region 231 may further include the camera 236 capable of obtaining an image from the outside through a portion of the first display region 231 and the sensor module 238 that generates an electrical signal or a data value corresponding to an external environmental condition. According to an embodiment, at least one of the sensor module 238 and the camera 236 may be included on a rear surface of the flexible display 230 corresponding to the first display region 231 or the second display region 232 of the flexible display 230. For example, at least one of the camera 236 and the sensor module 238 may be disposed under the flexible display 230 and surrounded by the flexible display 230. The at least one of the camera 236 and the sensor module 238 may not be exposed to the outside by being surrounded by the flexible display 230. However, it is not limited thereto, and the flexible display 230 may include an opening that exposes the camera 236 and the sensor module 238 to the outside. Although not illustrated in FIGS. 2A and 2B, in an embodiment, the flexible display 230 may further include a rear surface opposite to the front surface. In an embodiment, the flexible display 230 may be supported by a first support member 270 of the first housing 210 and a second support member 280 of the second housing 220.

In an embodiment, the hinge structure 260 may be configured to rotatably connect the first support member 270 that forms the first housing 210 and is fastened to the first hinge plate 266, and the second support member 280 that forms the second housing 220 and is fastened to the second hinge plate 267.

In an embodiment, the hinge cover 265 surrounding the hinge structure 260 may be at least partially exposed through a space between the first housing 210 and the second housing 220 while the electronic device 101 is in the folded state. In another embodiment, the hinge cover 265 may be covered by the first housing 210 and the second housing 220 while the electronic device 101 is in the unfolded state.

In an embodiment, the electronic device 101 may be folded based on a folding axis 237 passing through the hinge cover 265. For example, the hinge cover 265 may be disposed between the first housing 210 and the second housing 220 of the electronic device 101 in order to enable the electronic device 101 to be bend, curve, and fold. For example, the first housing 210 may be connected to the second housing 220 through the hinge structure 260 mounted on the hinge cover 265, and may rotate with respect to the folding axis 237. For example, the hinge structure 260 may include hinge modules 262 disposed at both ends of the first hinge plate 266 and the second hinge plate 267. As the hinge module 262 includes hinge gears engaged with each other therein, the hinge module 262 may rotate the first hinge plate 266 and the second hinge plate 267 with respect to the folding axis. The first housing 210 coupled to the first hinge plate 266 may be connected to the second housing 220 coupled to the second hinge plate 267, and rotate with respect to the folding axis by hinge modules 262.

In an embodiment, the electronic device 101 may be folded, such that the first housing 210 and the second housing 220 face each other by rotating with respect to the folding axis 237. In an embodiment, the electronic device 101 may be folded so that the first housing 210 and the second housing 220 stack or overlap each other.

Referring to FIG. 2C, the electronic device 101 may include the first support member 270, the second support member 280, the hinge structure 260, the flexible display 230, the printed circuit board 250, a battery 255, the hinge cover 265, an antenna 285, the display panel 235, and a rear plate 290. According to an embodiment, the electronic device 101 may omit at least one of components or may additionally include another component. At least one of components of an electronic device 300 may be the same as or similar to at least one of the components of the electronic device 101 of FIG. 1, 2A, or 2B, and a redundant description will be omitted below.

In an embodiment, the first housing 210 and the second housing 220 may support a flexible display (e.g., the flexible display 230 of FIG. 2A). A flexible display panel may include a front surface that emits light to provide information and a rear surface facing the front surface. In case that a first surface (e.g., the first surface 211 of FIG. 2A) of the first housing 210 faces a third surface (e.g., the third surface 221 of FIG. 2A) of the second housing 220, the flexible display panel may be in the folded state that a surface in which the first display region 231 of the flexible display panel views and a surface in which the second display region 232 views face each other. In case that the first surface 211 of the first housing 210 and the third surface 221 of the second housing 220 views the same direction, the flexible display 230 may be in the unfolded state that the first display region 231 and the second display region 232 of the flexible display 230 views the same direction.

In an embodiment, the electronic device 101 may provide an unfolded state in which the first housing 210 and the second housing 220 are fully folded out by the hinge structure 260. The first support member 270 may be connected to the second support member 280 through the hinge structure 260 to switch the electronic device 101 into the folded state or the unfolded state. The first support member 270 and the second support member 280 attached to the hinge plates 266 and 267 of the hinge structure 260 may move, by rotation of a hinge gear 263. The hinge plates 266 and 267 may include the first hinge plate 266 coupled to the first support member 270 and the second hinge plate 267 coupled to the second support member 280. The electronic device 101 may be switched to the folded state or the unfolded state, by the rotation of the hinge gear 263.

In an embodiment, the hinge structure 260 may include the hinge module 262, the first hinge plate 266, and the second hinge plate 267. The hinge module 262 may include the hinge gear 263 enabling the first hinge plate 266 and the second hinge plate 267 to be pivotable. The hinge gear 263 may rotate the first hinge plate 266 and the second hinge plate 267 while being engaged with each other to rotate. The hinge module 262 may be a plurality of hinge modules. Each of the plurality of hinge modules may be disposed at both ends formed by the first hinge plate 266 and the second hinge plate 267.

In an embodiment, the first hinge plate 266 may be coupled to the first support member 270 of the first housing 210, and the second hinge plate 267 may be coupled to the second support member 280 of the second housing 220. The first housing 210 and the second housing 220 may rotate to correspond to rotation of the first hinge plate 266 and the second hinge plate 267.

In an embodiment, the first housing 210 may include the first support member 270, and the second housing 220 may include the second support member 280. The first support member 270 may be partially surrounded by the first lateral side 213. The second support member 280 may be partially surrounded by the second lateral side 223. The first support member 270 may be integrally formed with the first lateral side 213. The second support member 280 may be integrally formed with the second lateral side 223. According to an embodiment, the first support member 270 may be formed separately from the first lateral side 213. The second support member 280 may be formed separately from the second lateral side 223. For example, the first lateral side 213 and the second lateral side 223 may be used as an antenna by being formed of a metal material, a non-metal material, or a combination thereof.

In an embodiment, the first support member 270 may be coupled to the flexible display 230 on a surface, and coupled to the rear plate 290 on another surface. In an embodiment, the second support member 280 may be coupled to the flexible display 230 on a surface, and coupled to the display panel 235 on another surface.

In an embodiment, the printed circuit board 250 and the battery 255 may be disposed between a surface formed by the first support member 270 and the second support member 280 and a surface formed by the display panel 235 and the rear plate 290. In an embodiment, the printed circuit board 250 may include a first printed circuit board 251 or a second printed circuit board 252 to be disposed in each of the first support member 270 of the first housing 210 and the second support member 280 of the second housing 220. For example, a shape of the first printed circuit board 251 disposed in the first support member 270 and a shape of the second printed circuit board 252 disposed in the second support member 280 may be different according to a space of the inside of the electronic device. Components for implementing various functions of the electronic device 10 may be mounted on the first printed circuit board 251 and the second printed circuit board 252. According to an embodiment, components for implementing the overall function of the electronic device 101 may be mounted on the first printed circuit board 251, and electronic components for implementing a portion of functions of the electronic device 101 may be disposed, or components for driving the display panel 235 disposed on the fourth surface 222 may be disposed on the second printed circuit board 252. For example, the first printed circuit board 251 and the second printed circuit board 252 may be electrically connected by a flexible printed circuit board 240.

In an embodiment, the battery 255 is, for example, a device for supplying power to at least one component of the electronic device 101, and may include, for example, a non-rechargeable primary battery, a rechargeable secondary battery, or a fuel cell. At least a portion of the battery 255 may be disposed on substantially the same plane as the printed circuit board 250. A surface formed as substantially the same plane of the printed circuit board 250 and the battery 255 may be disposed on a surface (e.g., a surface facing the second surface 212 and the fourth surface 222 or a surface facing the display panel 235 and the rear plate 290) of the first support member 270 and the second support member 280. For example, the flexible display 230 may be disposed in the first surface 211 and the third surface 221.

In an embodiment, the antenna 285 may be disposed between the rear plate 290 and the battery 255. The antenna 285 may include, for example, a near field communication (NFC) antenna, a wireless charging antenna, and/or a magnetic secure transmission (MST) antenna. The antenna 285 may, for example, perform short-range communication with an external device or wirelessly transmit and receive power required for charging.

In an embodiment, the printed circuit board 250 may be disposed inside the electronic device 101, which is a foldable electronic device including the first housing 210 and/or the second housing 220. However, it is not limited thereto, and the electronic device 101 including the printed circuit board 250 may be a portable terminal including one housing. The electronic device 101 may be a rollable electronic device including a housing capable of sliding out or sliding in from a fixed housing. A structure of the printed circuit board 250 to be described later is not limited to a structure of the electronic device, and may be applied to various types of electronic devices. For example, the electronic device 101 may be any electronic device including the printed circuit board 250 including an interposer. The electronic device may be one of a smartphone, a PC, a tablet PC, or home appliances.

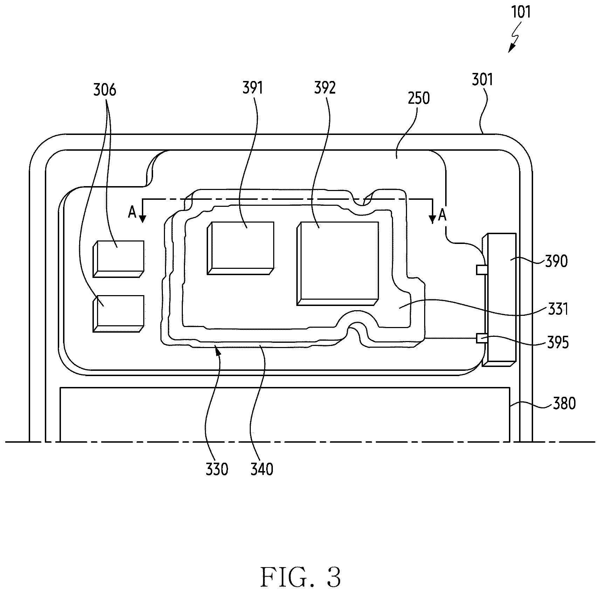

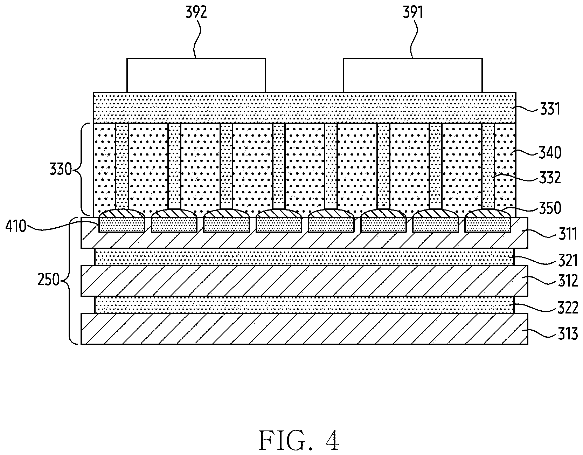

In an embodiment, the printed circuit board 250 may stack a plurality of substrates to dispose an electronic component due to a limitation of a mounting space inside the housing 210 or 220. For example, the plurality of substrates may be electrically connected to the printed circuit board 250 by disposing an interposer on the printed circuit board 250. A disposition and a structure of the printed circuit board 250, the interposer, and the substrate will be described in detail based on FIGS. 3 and 4.

FIG. 3 is a perspective view of a printed circuit board in which an exemplary interposer in an electronic device is disposed according to an embodiment.

Referring to FIG. 3, an electronic device 101 may include a housing 301, a printed circuit board 250, an interposer 330 and/or a substrate 331. The housing 301 may form a portion of an exterior of the electronic device 101. The housing 301 may define an inner space of the electronic device 101. The housing 301 may be formed as one housing, but is not limited thereto, and may include a plurality of housings. For example, the housing 301 may include a first housing (e.g., the first housing 210 of FIG. 2A) and a second housing (e.g., the second housing 220 of FIG. 2A). The first housing 210 and the second housing 220 may face each other or may be unfolded out according to a state of the electronic device 101.

According to an embodiment, the printed circuit board 250 may be disposed inside the housing 310. For example, the printed circuit board 250 may be disposed in an inner space formed by the housing 310. Electronic components 306 implementing a function of the electronic device 101 may be disposed in the printed circuit board 250. For example, the electronic components 306 may include a chip or integrated circuit such as a processor (e.g., the processor 120 of FIG. 1), a memory (e.g., the memory 130 of FIG. 1), and a power management integrated circuit (PMIC).

According to an embodiment, the interposer 330 may be disposed on the printed circuit board 250. The interposer 330 may include a sidewall 340. The sidewall 340 of the interposer 330 may be interposed between the printed circuit board 250 and the substrate 331 facing the printed circuit board 250. The sidewall 340 may be extended on the printed circuit board 250 while having a closed curve. The sidewall 340 may separate the printed circuit board 250 and the substrate 331 from each other. In an embodiment, electronic components (not illustrated) may be disposed in a space between the printed circuit board 250 and the substrate 331. The interposer 330 may electrically connect the substrate 331 and the printed circuit board 250. For example, the interposer 330 may electrically connect the substrate 331 and the printed circuit board 250 through a plurality of conductive vias formed in the sidewall 340. Electronic components 391 and 392 disposed on the substrate 331 may be electrically connected to the printed circuit board 250 through the interposer 330. According to an embodiment, the interposer 330 may be formed in a direction perpendicular to the printed circuit board 250 to secure mounting space that is insufficient in the electronic device.

According to an embodiment, the electronic device 101 may further include a battery 380 (e.g., the battery 255 of FIG. 2C) electrically connected to the printed circuit board 250 and an antenna 390. The battery 380 may supply power to the electronic components 306, 391, and 392. The antenna 390 may wirelessly communicate with an external electronic device (e.g., the electronic device 102 or the electronic device 104 of FIG. 1). The antenna 390 may be configured to transmit a wireless communication signal transmitted from the processor (e.g., processor 120 of FIG. 1) among the electronic components 306, 391, and 392 to the outside, or to receive a wireless communication signal from the outside. The antenna 390 may be electrically connected to the printed circuit board 250 through a connector or a connection member 395 (e.g., contact or connector).

According to an embodiment, the electronic device 101 may include additional electronic components 391 and 392 on the printed circuit board 250. For example, the additional electronic components 391 and 392 may be disposed in the substrate 331 on the interposer 330. For example, a structure of the interposer 330 and the printed circuit board 250 may be illustrated through FIG. 4.

FIG. 4 is a cross-sectional view of a printed circuit board on which an exemplary interposer is disposed, cut along line A-A' of FIG. 3, according to an embodiment.

Referring to FIG. 4, a printed circuit board 250 may include a first non-conductive layer 311, a second non-conductive layer 312, and a third non-conductive layer 313.

According to an embodiment, the first non-conductive layer 311 may be the outermost layer of the printed circuit board 250. For example, the first non-conductive layer 311 may face an interposer 330. The first non-conductive layer 311 may include a plurality of conductive pads 410 disposed on a surface facing the interposer 330. The plurality of conductive pads 410 may be electrically connected to conductive patterns 321 and 322 inside the printed circuit board 250. For example, the plurality of conductive pads 410 may be electrically connected to the conductive patterns 321 and 322 inside the printed circuit board 250 through a conductive via. The plurality of conductive pads 410 may be connected to a plurality of solders 350. For example, the plurality of solders 350 may be disposed on the plurality of conductive pads 410. The plurality of solders 350 may be disposed between the printed circuit board 250 and the interposer 330. The first non-conductive layer 311 may be disposed on the second non-conductive layer 312. The first non-conductive layer 311 may surround first conductive patterns 321 disposed on the second non-conductive layer 312. According to an embodiment, the first non-conductive layer 311 may include a polymer material. For example, the first non-conductive layer 311 may be a prepreg. The first non-conductive layer 311 may provide an insulating layer or a dielectric layer of the printed circuit board 250.

According to an embodiment, the second non-conductive layer 312 may be positioned on a surface of the first non-conductive layer 311 opposite to another surface of the first non-conductive layer on which the conductive pads 410 are disposed. The first conductive patterns 321 may be disposed on the second non-conductive layer 312. For example, the first conductive patterns 321 may be disposed on a surface of the second non-conductive layer 312 facing the other surface of the first non-conductive layer 311. For example, the first conductive patterns 321 may be printed on a surface of the second non-conductive layer 312. According to an embodiment, the second non-conductive layer 312 may include the polymer material. For example, the second non-conductive layer 312 may be the prepreg. The second non-conductive layer 312 may provide the insulating layer or the dielectric layer of the printed circuit board 250.

According to an embodiment, the third non-conductive layer 313 may support the second non-conductive layer 312. For example, the third non-conductive layer 313 may face a surface opposite to another surface of the second non-conductive layer 312 on which the first conductive patterns 321 are printed. Second conductive patterns 322 may be disposed on the third non-conductive layer 313. For example, the second conductive patterns 322 may be printed on a surface of the third non-conductive layer 313. The first conductive patterns 321 and the second conductive patterns 322 may include at least one of a signal line, a communication line, and a power line. Although the printed circuit board 250 is described as including three non-conductive layers, it is not limited thereto. The printed circuit board 250 may include four or more non-conductive layers. In an embodiment, one of the non-conductive layers may be a core layer, and the rest may be the prepreg.

According to an embodiment, the interposer 330 may further include a sidewall 340 and a substrate 331. The sidewall 340 may be disposed between the substrate 331 and the first non-conductive layer 311. The interposer 330 may further include conductive vias 332 penetrating the sidewall 340. For example, the conductive vias 332 may electrically connect a plurality of electronic components 391 and 392 disposed on the substrate 331 to the printed circuit board 250. The conductive vias 332 may be connected to the solders 350. The conductive vias 332 may electrically connect the printed circuit board 250 and the electronic components 391 and 392 through the conductive pads 410 in contact with the solders 350.

According to an embodiment, the plurality of solders 350 may be aligned in a plurality of rows to correspond to a shape of the interposer 330. For example, the plurality of solders 350 may be aligned in the plurality of rows within a region where the sidewall 340 of the interposer 330 and the printed circuit board 250 are in contact. According to an embodiment, the plurality of solders 350 may be disposed along a periphery of the interposer 330. For example, the plurality of solders 350 may be disposed along a region between the sidewall 340 and the printed circuit board 250. For example, the plurality of solders 350 may be disposed to correspond to the conductive vias 332.

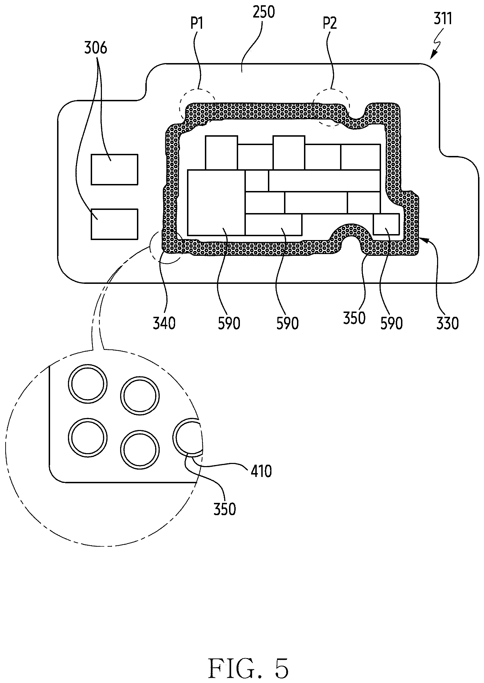

According to an embodiment, the interposer 330 may be electrically connected to the printed circuit board 250 through the plurality of solders 350 and joined to the printed circuit board 250. For example, the plurality of solders 350 may provide a joint between the printed circuit board 250 and the interposer 330. The joint may be a portion vulnerable to external impact. For example, the joint may be a stress concentration region. Due to stress concentrated on the joint, the first non-conductive layer 311, the second non-conductive layer 312, and the first conductive patterns 321 may be vulnerable to cracks. The printed circuit board 250 of the electronic device 101 may include a structure of the first conductive patterns 321 for preventing damage to conductive patterns that transmit a signal, power, or data. For example, the structure of the first conductive patterns 321 may be illustrated through FIGS. 5 to 7.

FIG. 5 is a top plan view of an exemplary first non-conductive layer on which a solder joint of a printed circuit board is displayed according to an embodiment.

Referring to FIG. 5, a first non-conductive layer 311 may include conductive pads 410. A plurality of solders 350 may be disposed between the conductive pads 410 and an interposer 330. The plurality of solders 350 may correspond to the conductive pads 410. For example, the plurality of solders 350 may be disposed on the corresponding conductive pads 410. For example, the conductive pads 410 may be disposed on the first non-conductive layer 311 along a sidewall 340 of the interposer 330. For example, the plurality of solders 350 and the conductive pads 410 may be aligned in a plurality of rows along a periphery of the interposer 330. For example, the plurality of solders 350 and the conductive pads 410 may be aligned in a plurality of rows within a region in contact with the sidewall 340 of the interposer 330. In an embodiment, the sidewall 340 of the interposer 330 may form a closed curve on the first non-conductive layer 311. Electronic components 306 may be disposed outside the closed curve formed by the sidewall 340 of the interposer 330. A plurality of electronic components 590 may be additionally disposed in an inner space formed through the sidewall 340 of the interposer 330.

According to an embodiment, the interposer 330 may be disposed on the conductive pads 410. When viewed from above the first non-conductive layer 311, the sidewall 340 of the interposer 330 may overlap the conductive pads 410 or the solders 350. The solders 350 may electrically connect conductive vias (e.g., the conductive vias 332 of FIG. 4) penetrating the sidewall 340 to the conductive pads 410. The solders 350 may join the interposer 330 and the first non-conductive layer 311.

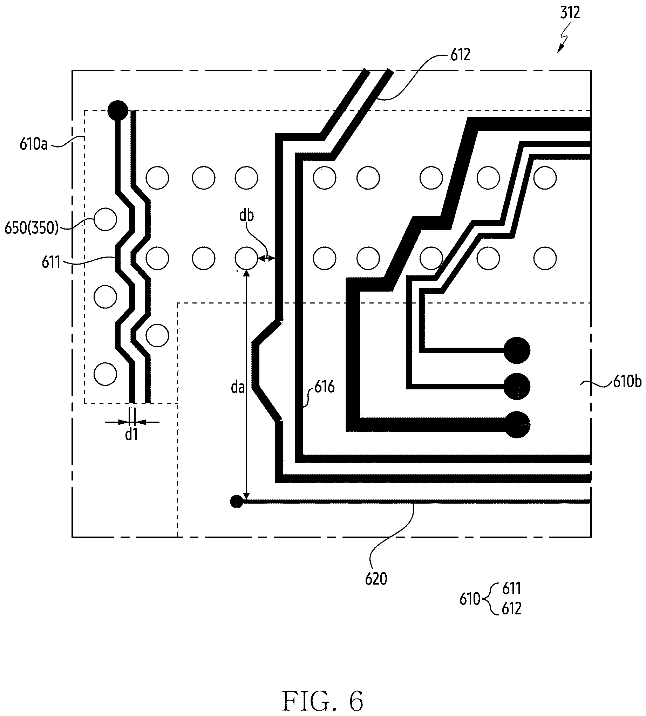

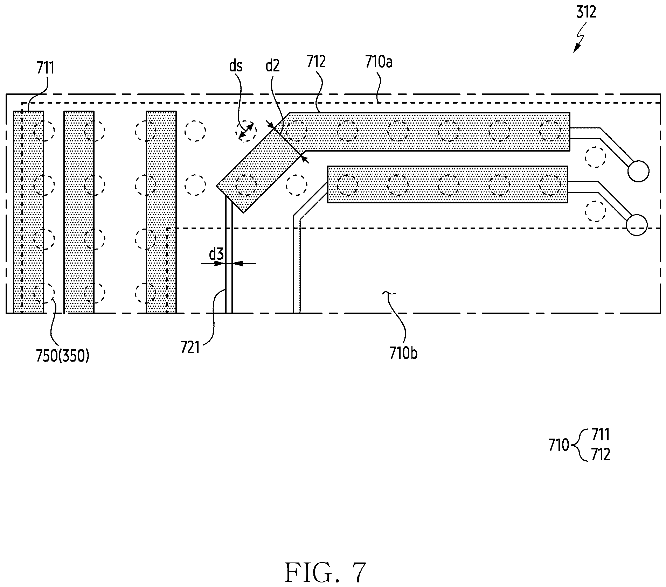

According to an embodiment, the interposer 330 may be formed in various shapes. The interposer 330 may be formed in a rectangular shape. According to an embodiment, a shape of the interposer 330 may be determined according to an arrangement of the electronic components 590 disposed inside the closed curve. For example, the sidewall 340 of the interposer 330 may be disposed to surround the electronic components 590. The interposer 330 may include regions (e.g., a region P1 or a region P2) that are bent according to the arrangement of the electronic components 590. For example, a shape of the sidewall 340 may protrude or be recessed from a periphery forming a polygon, through the region P1 and the region P2. In the interposer 330, stress may be concentrated in the region P1 and/or the region P2 that are bent. Cracks may occur in the region P1 and/or the region P2 of the first non-conductive layer 311 by concentration of stress. The cracks may occur not only in the first non-conductive layer 311 but also in a second non-conductive layer 312, and first conductive patterns 321 disposed on the second non-conductive layer 312. A structure of the conductive patterns 321 for preventing the cracks of the first conductive patterns 321 will be described based on FIGS. 6 and 7.

FIG. 6 is a top plan view of an exemplary second non-conductive layer on which a conductive pattern of a printed circuit board is printed according to an embodiment.

Referring to FIG. 6, a second non-conductive layer 312 may include a first region 610a including portions overlapping first solders 650 among a plurality of solders 350 when the printed circuit board (e.g., the printed circuit board 250 of FIG. 3) is viewed from above. According to an embodiment, the first region 610a may be a portion of a region in which a sidewall 340 (e.g., the sidewall 340 of FIG. 3) of an interposer 330 (e.g., the interposer 330 of FIG. 3) overlaps the second non-conductive layer 312 when the printed circuit board 250 is viewed from above. A first portion 611 or 612 of a first conductive line 610 disposed on the first region 610a may be spaced apart from a portion overlapping the first solders 650 when the printed circuit board 250 is viewed from above. For example, the first portion 611 or 612 may be bent to be spaced apart from a portion of the second non-conductive layer 312 overlapping the first solders 650 when the printed circuit board 250 is viewed from above. For example, the first portion 611 of the conductive pattern may include a meander line extending along a space between the first solders 650 when the printed circuit board 250 is viewed from above. For example, the first portion 611 may not overlap the first solders 650 when the printed circuit board 250 is viewed from above. The first portion 611 may include a portion that is bent within the first region 610a. The first portion 611 or 612 may be bent to be spaced apart from the portion overlapping the first solders 650. For example, the first portion 611 or 612 may extend in a straight line and then may be bent to maintain a designated distance range from one of the first solders 650. For example, as the first portion 611 or 612 is bent, the first portion 611 or 612 may be spaced apart from the one of the portions overlapping the first solders 650 in the second non-conductive layer 312 by the designated distance or more.

According to an embodiment, a first conductive pattern (e.g., the first conductive pattern 321 of FIG. 4) disposed on the second non-conductive layer 312 may include first conductive lines 610 and a second conductive line 620. According to an embodiment, the first portion 611 or 612 of the first conductive lines 610 may reduce external impact transmitted through the solders 650 by being spaced apart from the portion overlapping the first solders 650 when the printed circuit board 250 is viewed from above. The portion overlapping the first solders 650 may directly receive external impact applied to the solders 650 through the first non-conductive layer 311 (e.g., the first non-conductive layer 311 of FIG. 4). The first conductive lines 610 spaced apart from the portion overlapping the first solders 650 may reduce cracks due to impact transmitted to the portion overlapping the first solders 650.

According to an embodiment, the first portion 611 or 612 of the first conductive lines 610 may prevent stress concentrated on the solders 650 from being transferred to the first portions 611 or 612, by being spaced apart from the portion overlapping the first solders 650. A joint by the first solders 650 may be a portion in which the stress is concentrated. Cracks in the printed circuit board 250 may occur at a portion joined to the first solders 650 in which the stress is concentrated. In an embodiment, in order to reduce a possibility of damage to the first conductive patterns 321 disposed under the first non-conductive layer 311 on which the first solders 650 are disposed, the first conductive patterns 321 may be spaced apart from a periphery of the first solders 650 by a designated distance or more.

According to an embodiment, the first conductive lines 610 may operate as a signal line or a power line. For example, the first conductive lines 610 may be electrically connected to a processor (e.g., the processor 120 of FIG. 1) on the printed circuit board 250. In an embodiment, the first conductive lines 610 may be configured to transmit a data signal from the processor 120 to other electronic components (e.g., the electronic components 306, 391, and 392 of FIG. 3). For example, the first conductive lines 610 may be electrically connected to a battery (e.g., the battery 380 of FIG. 3). The first conductive lines 610 may be configured to supply power to the electronic components 306, 391, and 392 in the electronic device through the battery 380.

According to an embodiment, it is described that the first conductive lines 610 are disposed in the first region 610a, but are not limited thereto. A portion 612 of one of the first conductive lines 610 may cross the first region 610a overlapping the interposer 330, and another portion 616 distinguished from the portion 612 may be disposed in a second region 610b distinguished from the first region 610a overlapping the interposer 330. For example, the portion 612 of one of the first conductive lines 610 may be bent several times in the first region 610a, and the other portion 616 of one of the first conductive lines 610 may extend in a straight line in the second region 610b.

According to an embodiment, the printed circuit board 250 may include the second conductive line 620 distinguished from the first conductive lines 610.

According to an embodiment, the second conductive line 620 may be disposed in the second region 610b distinguished from the first region 610a on the second non-conductive layer 312. The second region 610b may be a region within a closed curve formed by the interposer 330. The second region 610b may be a region in which influence of stress concentration according to joining of the interposer 330 and the printed circuit board 250 is relatively small. For example, the second conductive line 620 disposed in the second region 610b may be a wiring that is difficult to adjust a width of the conductive line 620 or a length of the conductive pattern 620. For example, the second conductive line 620 may be a line in which impedance control is difficult. The second conductive line 620 may operate as an RF signal transmission line. For example, the second conductive line 620 may be configured to transmit a wireless communication signal from the processor 120 to an antenna (e.g., the antenna 390 of FIG. 3). For example, the second conductive line 620 may be a mobile industry processor interface (MIPI) line. For example, the first conductive lines 610 or the second conductive line 620 may be referred to as a conductive line in terms of transmitting a signal, data, or power.

According to an embodiment, the shortest distance (db) among distances between the plurality of first solders 650 and the first conductive pattern 611 or 612 may be closer than distances (da) between the plurality of first solders 650 and the second conductive line 620. For example, the second conductive line 620 may be disposed relatively far from the first solders 650 compared to the first conductive lines 610, thereby being spaced apart from a stress concentration region according to joining of the first solders 650.

When the printed circuit board 250 according to the above-described embodiment is viewed from above, the printed circuit board 250 may reduce damage to the first conductive lines 610 by disposing the first conductive lines 610 not to overlap the first solders 650. For example, when the printed circuit board 250 is viewed from above, in the case that the first conductive lines 610 are disposed across the first solders 650 in the first region 610a, the first conductive lines 610 in the region overlapping the first solders 650 may be damaged. In an embodiment, as the first conductive lines 610 are disposed between the first solders 650 and are disposed by avoiding the first solders 650, damage to the first conductive lines 610 may be reduced. By separating the second conductive line 620 that is relatively difficult to deform, from the overlapping region of the first solders 650, a possibility of damage to the second conductive line 620 may be reduced.

FIG. 7 is a top plan view of an exemplary second non-conductive layer on which a wide conductive pattern of a printed circuit board is printed according to an embodiment.

The first conductive lines 610 of FIG. 6 disposed on a second non-conductive layer 312 may be a conductive line or a conductive track, different from third conductive lines 710 of FIG. 7.

Referring to FIG. 7, the second non-conductive layer 312 may include a third region 710a including portions overlapping second solders 750 among a plurality of solders 350 when the printed circuit board (e.g., the printed circuit board 250 of FIG. 3) is viewed from above. According to an embodiment, the third region 710a may be a portion of a region in which a sidewall 340 (e.g., the sidewall 340 of FIG. 3) of an interposer 330 (e.g., the interposer 330 of FIG. 3) overlaps the second non-conductive layer 312 when the printed circuit board 250 is viewed from above. A first region 610a may be substantially the same region as the third region 710a. For example, the first region 610a and the third region 710a may be the region P1 of FIG. 5. For example, the first region 610a and the third region 710a may be the region P2 of FIG. 5. A second portion 711 or 712 of the third conductive lines 710 disposed on the third region 710a may overlap the second solders 750 when the printed circuit board 250 is viewed from above. The second portion 711 or 712 is indicated to extend in a straight line in the third region 710a, but is not limited thereto. The second portion 711 or 712 may be disposed to be bent in the third region 710a. For example, a portion 711 of the second portion 711 or 712 may extend in a straight line in the third region 710a, and another portion 712 of a first portion 711 or 712 may be bent in the third region 710a.

According to an embodiment, the second portion 711 or 712 of the third conductive lines 710 disposed in the third region 710a may be thicker than another portion (e.g., the first portion 611 or 612) of the first conductive lines 610. For example, a width d2 of the second portion 711 or 712 of the third conductive lines 710 disposed on the third region 710a may be wider than a width d1 of the first portion 611 or 612 of the first conductive lines 610.

According to an embodiment, the second portion 711 or 712 in the third region 710a of the third conductive lines 710 may be thicker than a third portion 721 in a fourth region 710b. For example, the width d2 of the third conductive lines 710 disposed on the third region 710a may be wider than a width d3 of the third conductive lines 710 disposed in the fourth region 710b. As the third conductive lines 710 disposed on the third region 710a are disposed to overlap the second solders 750 among the plurality of solders 350, stress may be concentrated. To reduce damage from the concentrated stress, the second portion 711 or 712 of the third conductive lines 710 in the third region 710a may be formed to have relatively high rigidity.

According to an embodiment, a length d2 corresponding to the width of the second portion 711 or 712 of the third conductive lines 710 disposed on the third region 710a may be longer than a width of the plurality of solders 350. For example, the length d2 corresponding to a thickness of the second portion 711 or 712 of the third conductive lines 710 may be longer than a diameter ds of each of the plurality of solders 350. For example, the width of the second portion of the conductive pattern may be about 0.15mm to 0.2mm. The diameter of the solders may be about 0.02 mm to 0.15 mm.

According to an embodiment, the second portion 711 or 712 of the second conductive lines 710 may operate as a signal line or a power line. The signal line or the power line may design a width of the line relatively freely. For example, a second conductive pattern (e.g., the second conductive line 620 of FIG. 6), which is an RF signal transmission line, is a line that is heavily influenced by impedance, and it may be difficult to adjust the width of the conductive pattern, making it difficult to dispose it in the third region 710a.

Referring to FIGS. 6 and 7, the third region 710a may be a different region from the first region 610a overlapping the interposer 330. For example, the first region 610a may be the region P1 of FIG. 5, and the third region 710a may be the region P2 of FIG. 5. However, it is not limited thereto. The first region 610a may be a region of the second non-conductive layer 312 overlapping the interposer 330, and the third region 710a may be another region of the second non-conductive layer 312 overlapping the interposer 330. A line of the first conductive lines 610 may be disposed in the first region 610a and may be connected to a line of the third conductive lines 710. The line of the third conductive lines 710 connected to the line of the first conductive lines 610 may extend to the third region 710a.

According to an embodiment, the first conductive lines 610 and the third conductive lines 710 may include the first portion 611 or 612 and/or the second portion 711 or 712. For example, the first portion 611 or 612 and/or the second portion 711 or 712 may be a conductive line connected to each other. In an embodiment, the first conductive lines 610 connected to the third conductive lines 710 may include the first portion 611 or 612. The first conductive lines 610 may be meanderingly disposed by avoiding the solders 350 in a region, and the third conductive lines 710 extending from the first conductive lines 610 may overlap the solders 350 in another region, and may be formed thick. The first conductive lines 610 may be spaced apart from portions overlapping the first solders 650 in the second non-conductive layer 312, and may be meanderingly extended between the portions overlapping the first solders 650. The third conductive lines 710 connected to the first conductive line 610 may include the second portion 711 or 712. The third conductive lines 710 may overlap the second solders 750, and may have a width thicker than that of another portion distinguished from the third portion 721. For example, the second portion 711 or 712 of the third conductive lines 710 may have a width thicker than a diameter of the second solders 750 in a region overlapping the second solders 750.

According to an embodiment, a portion of the first conductive lines 610 and the third conductive lines 710 may be meanderingly disposed by avoiding the solders 350, and another portion may overlap the solders 350 and have a relatively thick width. For example, the first conductive lines 610 of the first conductive lines 610 and the third conductive lines 710 may be meanderingly disposed by avoiding the solders 350 in the first region 610a, and the third conductive lines 710 may overlap the solders 350 in the third region 710a and have a relatively thick width.

According to an embodiment, a portion (e.g., the first conductive lines 610) of the first conductive lines 610 and the third conductive lines 710 may cross only the first region 610a, and another portion (e.g., the third conductive lines 710) of the first conductive lines 610 and the third conductive lines 710 may cross only the third region 710a. However, it is not limited thereto, and a conductive line of the portion of the first conductive lines 610 and the third conductive lines 710 may cross at least a portion of the first region 610a and at least a portion of the third regions 710a. For example, a portion of the first conductive lines 610 may be connected to a portion of the third conductive lines 710.

According to the above-described embodiment, the printed circuit board 250 may reduce influence of a conductive pattern (e.g., the first conductive lines 610 and the third conductive lines 710) adjacent to the plurality of solders 350 by stress concentration caused based on joining of the plurality of solders 350. Among the conductive patterns disposed in the printed circuit board 250, the first conductive lines 610 overlapping a periphery of the interposer 330 may be disposed to avoid the solders 350 or may have a width wider than a diameter of each of the solders 350. The first conductive lines 610 disposed to avoid the solders 350 may reduce the influence of stress concentration. The first conductive lines 610 formed thicker than the solders 350 may reduce a possibility of cracks due to the stress concentration, by having relatively strong rigidity.

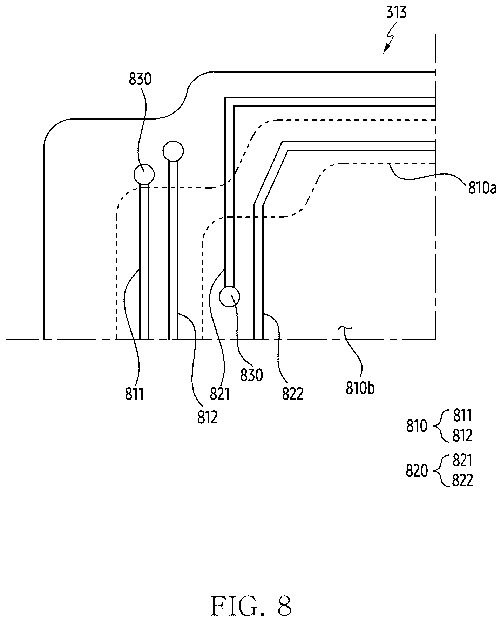

FIG. 8 is a top plan view of an exemplary third non-conductive layer of a printed circuit board according to an embodiment.

Referring to FIG. 8, a third non-conductive layer 313 may include fourth conductive lines 810 or fifth conductive lines 820. A second conductive pattern (e.g., the second conductive pattern 322 of FIG. 3) disposed on the third non-conductive layer 313 may include the fourth conductive lines 810 and the fifth conductive lines 820. A printed circuit board 250 (e.g., the printed circuit board 250 of FIG. 3) may include the third non-conductive layer 313 disposed in a direction in which a surface of a second non-conductive layer 312 faces, the surface being opposite to another surface of the second non-conductive layer 312 facing a first non-conductive layer 311. According to an embodiment, the fourth conductive lines 810 or the fifth conductive lines 820 may be disposed between the second non-conductive layer 312 and the third non-conductive layer 313.

According to an embodiment, the fourth conductive lines 810 may be electrically connected to a first conductive pattern 321. For example, the fourth conductive lines 810 may be disposed in a region where it is difficult to form a minder line shape that extends by bending among the first conductive pattern 321, or is difficult to form a line width larger than a diameter of a solder. A portion 811 of the fourth conductive lines 810 may be electrically connected to the first conductive pattern 321 through a conductive via 830. A line 811 of the fourth conductive lines 810 may be configured to supply power to components in the electronic device through a battery (e.g., the battery 380 of FIG. 3). A remaining line 812 of the fourth conductive lines 810 may be electrically connected to a processor (e.g., the processor 120 of FIG. 1) on the printed circuit board 250. The remaining line 812 of the fourth conductive lines 810 may be configured to transmit a data signal from the processor 120 to other electronic components (e.g., the electronic components 306, 391, and 392 of FIG. 3).

According to an embodiment, the fourth conductive lines 810 may be electrically connected to first conductive lines (e.g., the first conductive lines 610 of FIG. 6 or the first conductive lines 610 of FIG. 7) through the conductive via 830. For example, the conductive via 830 may connect one of the first conductive lines 610 and one of the fourth conductive lines 810. The conductive via 830 may be disposed between one of the first conductive lines 610 and one of the fourth conductive lines 810. The fourth conductive lines 810 may overlap the plurality of solders 350 when the printed circuit board 250 is viewed from above. The conductive via 830 may be spaced apart from a region 810a overlapping an interposer 330. Although it is described that the first conductive lines 610 are connected to the fourth conductive lines 810, the first conductive lines 610 may be connected to the fifth conductive lines 820.

According to an embodiment, a line 821 of the fifth conductive lines 820 may be electrically connected to the first conductive pattern 321. For example, a conductive line may be formed as the line 821 of the fifth conductive lines 820 in the region 810a overlapping the interposer 330, and may be formed as the first conductive pattern 321 in an inner region 810b that does not overlap the interposer 330. The line 821 of the fifth conductive lines 820 may be electrically connected to the first conductive pattern 321 through the conductive via 830. In an embodiment, the conductive via 830 may be disposed in the inner region 810b.

According to an embodiment, the conductive line may be formed of a conductive line disposed on the third non-conductive layer 313. For example, another line 822 of the fifth conductive lines 820 may extend on the third non-conductive layer 313.

According to an embodiment, a portion of a conductive pattern of the first conductive lines 610 may be meanderingly disposed by avoiding the solders 350, another portion of the conductive pattern of the first conductive lines 610 may overlap the solders 350 and have a relatively thick width, and a remaining conductive pattern of the first conductive lines 610 may be electrically connected to the fourth conductive lines 810 through the conductive via 830. For example, the first conductive lines 610 may be meanderingly disposed by avoiding the solders 350 in a first region 610a, and may be electrically connected to the fourth conductive lines 810 through the conductive via 830. For example, the first conductive lines 610 have a thicker width than the solders 350 in a third region 710a, and may be electrically connected to the fourth conductive lines 810 through the conductive via 830.

According to an embodiment, the fifth conductive lines 820 may be configured to transmit a wireless communication signal from the processor 120 to an antenna 390. The fifth conductive lines 820 may cross the region 810a overlapping the plurality of solders 350 among the third non-conductive layer 313. For example, the fifth conductive lines 820 may be electrically connected to a second conductive line 620 of the first conductive pattern 321. For example, the second conductive line 620 and the fifth conductive line 820 may be a line that transmits a RF signal. As the fourth conductive lines 810 and the fifth conductive lines 820, disposed on the third non-conductive layer 313 are relatively far from the first conductive lines 610 positioned between the first non-conductive layer 311 and the second non-conductive layer 312, influence caused by stress applied to the plurality of solders 350 is less, thereby being freely disposed on the third non-conductive layer 313 than the first conductive lines 610 and the second conductive line 620.

The printed circuit board 250 according to the above-described embodiment may reduce influence of the conductive pattern by stress concentration caused based on joining of the plurality of solders 350. In a region (e.g., the region P1 or the region P2 of FIG. 5) in which the stress is concentrated among conductive patterns disposed in the printed circuit board 250, the conductive patterns may extended to avoid the solders 350, the conductive patterns may have a wider width than the diameter of the solders 350, or the conductive patterns may be disposed on the third non-conductive layer that is relatively less affected by the stress concentration according to joining of the solders 350. The first conductive lines 610 disposed to avoid the solders 350 may reduce the influence of the stress concentration. The first conductive lines 610 formed thicker than the solders 350 may reduce the possibility of cracks due to stress concentration by having relatively strong rigidity. The conductive patterns may reduce the cracks due to the stress concentration by being disposed on the third non-conductive layer far from the solders 350.

According to the above-described embodiment, an electronic device (e.g., the electronic device 101 of FIG. 3) may comprise a printed circuit board (e.g., the printed circuit board 250 of FIG. 3). The printed circuit board may include a first non-conductive layer (e.g., the second non-conductive layer 321 of FIG. 4), a conductive pattern (e.g., the first conductive patterns 321 of FIG. 4) disposed on the first non-conductive layer, a second non-conductive layer (e.g., the first non-conductive layer 311 of FIG. 4) that surrounds the conductive pattern and is disposed on the first non-conductive layer. The electronic device may further include an interposer (e.g., the interposer 330 of FIG. 4) disposed on the second non-conductive layer. The electronic device may include a plurality of solders (e.g., the plurality of solders 350 of FIG. 4) disposed between the interposer and the second non-conductive layer, and disposed along at least a portion of a periphery of the interposer. The first non-conductive layer may include a first region (e.g., the first region 610a of FIG. 6) including portions overlapping first solders among the plurality of solders when the printed circuit board is viewed from above. A first portion (e.g., the first portion 611 or 612 of FIG. 6) of the conductive pattern disposed on the first region may be spaced apart from a periphery of the portions of the first non-conductive layer overlapping the first solders, and may extend to bend along a portion of the periphery when the printed circuit board is viewed from above.

The electronic device according to the above-described embodiment may reduce cracks of the conductive pattern by disposing the conductive pattern disposed under the solders not to overlap with the solders. By reducing the crack of the conductive pattern, the lifetime of the electronic device may be improved.

According to an embodiment, the first portion of the conductive pattern may meanderingly extend along a space between the first solders.

The conductive pattern according to the above-described embodiment may avoid a region overlapping the solders by being meanderingly extended from the first portion. By avoiding the region overlapping the solders, the conductive pattern may reduce influence of stress concentration caused by joining of the solder.

According to an embodiment, the first portion of the conductive pattern may be spaced apart from the portion overlapping the first solders to reduce external impact transmitted through the solders.

According to an embodiment, the first non-conductive layer may include a second region (e.g., the second region 710a of FIG. 7) including portions overlapping second solders (e.g., the second solders 750 of FIG. 7) of the plurality of solders when the printed circuit board is viewed from above. According to an embodiment, a width of a second portion (e.g., the second portion 711 or 712 of FIG. 7) of the conductive pattern disposed on the second region may be wider than a width of the first portion of the conductive pattern. The second portion of the conductive pattern may overlap the second solders.

The printed circuit board according to the above-described embodiment may prevent damage to the conductive pattern by increasing a thickness of the conductive pattern overlapping the solders. The conductive pattern may increase rigidity of the conductive pattern in a region where a possibility of cracks exists by increasing the thickness in the region overlapping the solders.

According to an embodiment, the width of the second portion of the conductive pattern disposed on the second region may be wider than a diameter of the plurality of solders. According to an embodiment, the width of the second portion of the conductive pattern may be 0.15 mm to 0.2 mm.

The printed circuit board according to the above-described embodiment may reduce damage to the conductive pattern caused by external impact or stress concentrated on the solders by making the width of the conductive pattern overlapping the solders thicker than the diameter of the solders.

According to an embodiment, the electronic device may further comprise conductive pads corresponding to each of the solders one-to-one and disposed between the solders and the first non-conductive layer.

According to an embodiment, the conductive pattern may be electrically connected to a processor on the printed circuit board and transmit a data signal.

According to an embodiment, the electronic device may further comprise a housing and a battery in the housing. According to an embodiment, the conductive pattern may be configured to supply power to electronic components in the electronic device through the battery.

According to an embodiment, an antenna wirelessly communicating with an external electronic device (e.g., the electronic device 102 or the electronic device 104 of FIG. 1) and a processor disposed on the printed circuit board may be further comprised. According to an embodiment, the printed circuit board may further include a conductive line distinct from the conductive pattern. The conductive line may be disposed in a closed curve defined by the interposer, on the first non-conductive layer. According to an embodiment, the conductive line may be configured to transmit a wireless communication signal transmitted from the processor to the antenna.

According to the above-described embodiment, since the conductive line is difficult to modify a length or a width of the conductive line, damage to the conductive line may be reduced by disposing it at a position relatively less affected by stress concentrated on the solders.

According to an embodiment, an antenna (e.g., the antenna 390 of FIG. 3) wirelessly communicating with an external electronic device (e.g., the electronic device 102 or the electronic device 104 of FIG. 1) and a processor (e.g., the processor 120 of FIG. 1) disposed on the printed circuit board may be further comprised. The printed circuit board may further include a third non-conductive layer disposed on a surface of the second non-conductive layer opposite to another surface of the second non-conductive layer facing the first non-conductive layer, and a conductive line disposed between the second non-conductive layer and the third non-conductive layer. The conductive line may be configured to transmit a wireless communication signal from the processor to the antenna.

According to an embodiment, the shortest distance among distances between each of the plurality of solders and the conductive pattern may be closer than each of distances between each of the plurality of solders and the conductive line.

According to an embodiment, the printed circuit board may further include the third non-conductive layer disposed on the surface of the second non-conductive layer opposite to the other surface of the second non-conductive layer facing the first non-conductive layer, the conductive line disposed between the second non-conductive layer and the third non-conductive layer, and the conductive via electrically connecting the conductive line and the conductive pattern. According to an embodiment, the conductive line may overlap the plurality of solders when the printed circuit board is viewed from above.

According to an embodiment, a substrate disposed on the interposer and distinct from the printed circuit board and an electronic component disposed on the substrate may be further included. According to an embodiment, the electronic component may be electrically connected to the printed circuit board through the interposer.

According to an embodiment, the interposer may include a plurality of conductive vias disposed on the solders to electrically connect the substrate and the printed circuit board.

According to an embodiment, the plurality of solders may be aligned in a plurality of rows along a periphery of the interposer.

According to an embodiment, an electronic device (e.g., the electronic device 101 of FIG. 3) may comprise a housing (e.g., the housing 301 of FIG. 3), a printed circuit board (e.g., the printed circuit board 250 of FIG. 3) disposed in the housing, an interposer (e.g., the interposer 330 of FIG. 3) disposed on conductive pads of the printed circuit board, and a plurality of solders (e.g., the plurality of solders 350 of FIG. 4) disposed between the interposer and the plurality of conductive pads. According to an embodiment, the printed circuit board may include a first non-conductive layer (e.g., the second non-conductive layer 312 of FIG. 4) in which the plurality of conductive pads are disposed on a surface, a second non-conductive layer (e.g., the first non-conductive layer 311 of FIG. 4) disposed on a surface of the first non-conductive layer opposite to the another surface of the first non-conductive layer, and a conductive pattern (e.g., the first conductive pattern 311 of FIG. 4) disposed between a first region of the second non-conductive layer including portions overlapping the plurality of solders and the first non-conductive layer when the printed circuit board is viewed from above. According to an embodiment, the conductive pattern may include a first portion (e.g., the first portion 611 or 612 of FIG. 6) that meanderingly extends between the portions overlapping the plurality of solders.

The electronic device according to the above-described embodiment may reduce cracks of the conductive pattern by disposing the conductive pattern disposed under the solders not to overlap with the solders. By reducing the crack of the conductive pattern, the lifetime of the electronic device may be improved. The conductive pattern may avoid a region overlapping the solders by being meanderingly extended from the first portion. By avoiding the region overlapping the solders, the conductive pattern may reduce influence of stress concentration caused by joining of the solder.

According to an embodiment, the first portion of the conductive pattern may be spaced apart from the portion overlapping the solders to reduce external impact transmitted through the solders.

The printed circuit board according to the above-described embodiment may reduce damage to the conductive pattern by separating the conductive pattern from the solders.

According to an embodiment, the second non-conductive layer may include a second region including portions overlapping second solders of the plurality of solders when the printed circuit board is viewed from above. According to an embodiment, a width of the conductive pattern disposed on the second region may be wider than a width of the first portion of the conductive pattern. The second portion of the conductive pattern may overlap the second solders.

According to an embodiment, the width of the second portion of the conductive pattern disposed on the second region may be wider than the width of the plurality of solders. According to an embodiment, the width of the second portion of the conductive pattern may be 0.15 mm to 0.2 mm.

The conductive pattern according to the above-described embodiment may reduce the influence by the solder, by increasing the width of the conductive pattern in the second portion. By increasing the rigidity in the region overlapping the solders, the conductive pattern may reduce the influence of stress concentration caused by joining of the solder.

According to an embodiment, the electronic device may further include a substrate disposed on the interposer and distinct from the printed circuit board, and an electronic component disposed on the substrate. According to an embodiment, the electronic component may be electrically connected to the printed circuit board through the interposer.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a printed circuit board (250) including:
a first non-conductive layer (311),
a second non-conductive layer (312) disposed on a surface of the first non-conductive layer (311), and
conductive patterns (321) disposed between the first non-conductive layer (311) and the second non-conductive layer (312);
an interposer (330) disposed on the first non-conductive layer (311); and
a plurality of solders (350) disposed along at least a portion of a periphery of the interposer (330) and disposed between the interposer (330) and the first non-conductive layer (311),
wherein the second non-conductive layer (312) includes a first region (610a) including portions overlapping with first solders (650) of the plurality of the solders (350) when the printed circuit board (250) is viewed from above, and
wherein a first portion (611, 612) of the conductive patterns (321) disposed on the first region (610a) is spaced apart from the portions overlapping with the first solders (650) of the second non-conductive layer (312) and extends to bend along a space between the overlapping portions when the printed circuit board (250) is viewed from above.

2. The electronic device (101) of claim 1, wherein the first portion (611, 612) of the conductive patterns (321) is disposed between the first solders (650) and includes a meander line.

3. The electronic device (101) of claim 1, wherein the first portion (611, 612) of the conductive patterns (321) is spaced apart from the portion overlapping with the first solders (650) on the second non-conductive layer (312) to reduce external impact transmitted through the solders (350).

4. The electronic device (101) of claim 1, wherein the second non-conductive layer (312) includes a second region (710a) including portions overlapping with second solders (750) of the plurality of the solders (350) when the printed circuit board (250) is viewed from above,
wherein a width of a second portion (711, 712) of the conductive patterns (321) disposed on the second region (710a) is wider than a width of the first portion (611, 612) of the conductive pattern (321), and
wherein the second portion (711, 712) of the conductive pattern (321) overlaps with the second solders (750) when the printed circuit board (250) is viewed from above.

5. The electronic device (101) of claim 4, wherein the width of the second portion (711, 712) of the conductive patterns (321) disposed on the second region (710a) is wider than a width of the plurality of the solders (350), and
wherein the width of the second portion (711, 712) of the conductive patterns (321) is 0.15 mm to 0.2 mm.

6. The electronic device (101) of claim 1, further comprising conductive pads (410) corresponding to each of the solders (350) and disposed between the solders (350) and the first non-conductive layer (311).

7. The electronic device (101) of claim 1, wherein the conductive patterns (321) are electrically connected to a processor (120) on the printed circuit board (250) and transmit a data signal.

8. The electronic device (101) of claim 1, further comprising:
a housing (301); and
a battery (380) in the housing (301), and
wherein the conductive patterns (321) are configured to supply power to electronic components (391, 392) in the electronic device (101) through the battery (380).

9. The electronic device (101) of claim 1, further comprising:
an antenna (390) wirelessly communicating with an external electronic device (102, 104); and
a processor (120) disposed on the printed circuit board (250), and
wherein the printed circuit board (250) further includes a conductive line (620) distinct from the conductive patterns (321), and
wherein the conductive line (620) is disposed in a closed curve defined by the interposer, on the second non-conductive layer (312), and transmit a wireless communication signal transmitted from the processor (120) to the antenna (390).

10. The electronic device (101) of claim 1, further comprising:
an antenna (390) wirelessly communicating with an external electronic device (102, 104); and
a processor (120) disposed on the printed circuit board (250);
wherein the printed circuit board (250) further includes:
a third non-conductive layer (313) disposed on a surface of the second non-conductive layer (312) opposite to another surface of the second non-conductive layer (312) facing the first non-conductive layer (311); and
a conductive line (820) disposed between the second non-conductive layer (312) and the third non-conductive layer (313), and
wherein the conductive line (820) is configured to transmit a wireless communication signal from the processor (120) to the antenna (390).

11. The electronic device (101) of claim 10, wherein a shortest distance among distances between each of the plurality of solders (350) and the conductive patterns (321) is closer than each of distances between each of the plurality of solders (350) and the conductive line (820).

12. The electronic device (101) of claim 1, wherein the printed circuit board (250) further includes:
a third non-conductive layer (313) disposed on a surface of the second non-conductive layer (312) opposite to another surface of the second non-conductive layer (312) facing the first non-conductive layer (311),
a conductive line (820) disposed between the second non-conductive layer (312) and the third non-conductive layer (313), and
a conductive via electrically connecting the conductive line (820) and the conductive patterns (321), and
wherein the conductive line (820) overlaps with the plurality of the solders (350), when the printed circuit board (250) is viewed from above.

13. The electronic device (101) of claim 1, further comprising:
a substrate, distinct from the printed circuit board (250), disposed on the interposer (330); and
an electronic component (391, 392) disposed on the substrate,
wherein the electronic component (391, 392) is electrically connected to the printed circuit board (250) through the interposer (330).

14. The electronic device (101) of claim 13, wherein the interposer (330) includes a plurality of conductive vias disposed on the solders (350) to electrically connect the substrate and the printed circuit board (250).

15. The electronic device (101) of claim 1, wherein the plurality of the solders (35 0) are aligned in a plurality of rows parallel to a periphery of the interposer (330).
